# EUROPÄISCHE PATENTSCHRIFT

(11) **EP 2 117 029 B1**
(45) Veröffentlichungstag und Bekanntmachung des Hinweises auf die Patenterteilung: **10.08.2016**
(21) Anmeldenummer: 09006184.7
(22) Anmeldetag: 06.05.2009
(51) Int. Cl.: H01J 37/32

(54) **Vorrichtung zur Modifizierung von Substratoberflächen**
Device for modifying substrate surfaces
Dispositif de modification de surfaces de substrat

(30) Priorität: 06.05.2008 DE 202008006477 U
(43) Veröffentlichungstag der Anmeldung: 11.11.2009
(73) Patentinhaber: Forschungs- und Applikationslabor Plasmatechnik GmbH Dresden, 01217 Dresden (DE)
(72) Erfinder: Steinke, Olaff, 01219 Dresden (DE); Stahr, Frank, 01477 Arnsdorf (DE); Stephan, Ulf, 01309 Dresden (DE)
(74) Vertreter: Pfenning, Meinig & Partner mbB

(56) Entgegenhaltungen:
- EP-A- 1 589 562
- EP-A- 1 887 609
- WO-A-2004/032175
- DE-A1- 2 939 167
- US-A1- 2004 112 537
- US-A1- 2005 001 527

## Beschreibung

Die Erfindung betrifft eine Vorrichtung zur Modifizierung von Substratoberflächen mit durch HF/VHF-Niederdruckgasentladungen gebildetem Plasma. Die Modifizierung kann beispielsweise ein Trockenätzen oder auch eine Beschichtung der Substratoberfläche sein. Dabei können bevorzugt ebene Oberflächen von Substraten behandelt und bevorzugt Schichten aus amorphem Silicium in reiner aber auch dotierter Form ausgebildet werden, so dass Halbleiterschichtsysteme für einen Einsatz in der Photovoltaik erhalten werden können.

Dabei wird in Vakuumkammern oder in evakuierten Bereichen von Kammern gearbeitet und das Plasma unter Einsatz eines der jeweiligen Modifizierung angepassten Prozessgases vorgenommen. Es werden Elektroden eingesetzt, die ebenfalls eine planare ebene Oberfläche aufweisen, die dann parallel zur Substratoberfläche ausgerichtet ist. Die Flächendimensionierung der Elektroden erfolgt dabei unter Beachtung der Breite bzw. der Gesamtfläche von Substraten, so dass die gesamte zu modifizierende Oberfläche möglichst homogen dem Plasmaeinfluss ausgesetzt werden kann.

Die Elektroden werden an einen HF/VHF-Generator angeschlossen und mit Frequenzen oberhalb 1 kHz betrieben. Außerdem kann eine automatische HF-Impedanzanpassungseinheit zwischen einer Elektrode und HF/VHF-Generator geschaltet sein. Ein solcher Aufbau ist beispielsweise in DE 102 01 992 beschrieben. Bei der daraus bekannten Vorrichtung können Substrate auch translatorisch an einer Elektrode vorbeigeführt und im Durchlauf gearbeitet werden. Es können auch mehrere solcher Aufbauten nacheinander angeordnet und so dann sukzessive unterschiedliche Modifizierungen an einer Substratoberfläche durchgeführt und dabei ggf. mehrere Schichten übereinander ausgebildet werden. Es liegt auf der Hand, dass der anlagentechnische Aufwand hierfür sehr hoch ist, da immer ein Vakuum eingehalten werden muss und für jede Elektrodeneinheit die erforderlichen elektrischen Elemente und eine Prozessgaszu- und eine solche -abführung vorhanden sein müssen.

Elektroden können aber auch nicht beliebig groß dimensioniert werden, um ein homogenes Plasma über die gesamte zu modifizierende Substratoberfläche einhalten zu können. Dies führt dazu, dass auch in Durchlaufanlagen die jeweilige möglich Größe der Substratoberfläche begrenzt ist.

Aus ökonomischer Sicht ist es aber gewünscht möglichst große Substratoberflächen in einem Durchgang modifizieren zu können und dabei aber auch die Kosten der erforderlichen Anlagentechnik sowie deren Betriebskosten gering zu halten.

Aus der den Oberbegriff des Anspruchs 1 bildenden WO 2004/032175 A1 ist eine Vorrichtung zur Behandlung eines bandförmigen Materials in einem PlasmaUnterstützten-Prozess bekannt. Dabei sind in einer Vakuumkammer mehrere voneinander unabhängige Magnetron-Elektroden vorhanden, die individuell von ihrer eigenen Spannungsquelle mit einer Wechselspannung gespeist werden.

Die DE 29 39 167 A1 betrifft eine Vorrichtung und ein Verfahren zur Leistungszuführung an eine von einem Entladungsplasma einer Zerstäubungsvorrichtung gebildeten Last.

Es ist daher Aufgabe der Erfindung Möglichkeiten zu schaffen, mit denen großflächige Substrate mit geringen Kosten und geringem anlagentechnischen Aufwand modifiziert werden können.

Erfindungsgemäß wird diese Aufgabe mit einer Vorrichtung, die die Merkmale des Anspruchs 1 aufweist, gelöst. Vorteilhafte Ausgestaltungen und Weiterbildungen können mit in untergeordneten Ansprüchen bezeichneten Merkmalen erreicht werden.

Bei der erfindungsgemäßen Vorrichtung für eine Oberflächenmodifizierung von Substraten, die translatorisch im Durchlauf oder bei einer Drehbewegung bearbeitet werden können, sind mindestens zwei elektrisch voneinander isolierte Elektroden vorhanden. Die zwei oder mehr Elektroden sind dabei in Vorschubachsrichtung der Substrate nacheinander angeordnet und jeweils mindestens zwei gemeinsam an einen HF/VHF-Generator angeschlossen. Außerdem sind zwischen in Vorschubachsrichtung nacheinander angeordneten Elektroden an ihren äußeren Rändern, also im Bereich der elektrischen Isolation entweder eine Prozessgaszuführung oder Prozessgasabführung angeordnet, die bei mehreren Elektroden alternierend angeordnet sein können. An der ersten und letzten Elektrode ist dann am jeweils nach außen weisenden Rand ebenfalls eine Prozessgaszuführung oder Prozessgasabführung vorhanden.

Die Elektroden haben ebenfalls eine zumindest in Richtung auf die zu modifizierenden Substratoberflächen weisend eine ebene planare Oberfläche. Bei einer Rotation von Substraten kann die Oberfläche der Elektroden auch entsprechend konkav gekrümmt sein.

Bevorzugt weisen die Elektroden eine rechteckige Form auf, so dass sie senkrecht zur Vorschubachsrichtung länger sind und die Breite B dann kleiner als die Länge L ist. Es sollte mindestens ein Verhältnis L : B von 1,5 : 1 eingehalten sein, was sich besonders günstig auf die Ausbildung eines über die Fläche homogenen Plasmas günstig auswirkt.

Wie bereits zum Ausdruck gebracht, kann der anlagentechnische Aufwand einmal durch die Nutzung eines HF/VHF-Generators für mehrere Elektroden und zusätzlich durch andere gemeinsam/zentral nutzbare Einrichtungen reduziert werden. So können mehrere oder auch alle Prozessgaszuführungen an eine gemeinsame zentrale Prozessgasversorgung angeschlossen sein. Dabei können auch unterschiedliche Prozessgase zu Verfügung stehen und die Zuführung dann mit Ventilen zu den Prozessgaszuführungen eingestellt werden, so dass ein Wechsel der Modifizierung der Substratoberfläche möglich ist. So kann beispielsweise erst geätzt und in einem nachfolgenden Durchlauf eine Beschichtung durchgeführt werden.

Dies schließt aber nicht aus, dass jede einzelne Prozessgaszuführung und dabei dann auch einzelne Austrittsöffnungen für Prozessgas, einzeln gesteuert oder geregelt werden können. Auch dies kann dafür sorgen, dass ein konstanter Partialdruck an Prozessgas über die gesamte Breite von zu modifizierenden Substratoberflächen beim Durchlaufen eingehalten werden kann, was zu einer homogenen Ausbildung von Plasma beiträgt und gleiche Verhältnisse bei der jeweiligen Modifizierung bewirken kann. Die Austrittsöffnungen von Prozessgaszuführungen können unterschiedlich gestaltet und dimensioniert sein. So können Loch- oder Schlitzdüsen vorhanden sein. Diese können eine Reihenanordnung mit mindestens einer Reihe bilden. Es ist auch eine versetzte Anordnung in mehreren Reihen möglich. In einigen Fällen kann es auch vorteilhaft sein, eine Kombination von Loch- und Schlitzdüsen zu wählen, die dann möglichst auch gesondert angesteuert werden können sollten. Dabei können dann einzelne Düsen geöffnet, geschlossen oder auch für den Durchlass unterschiedlicher Prozessgasvolumenströme entsprechend angesteuert oder geregelt werden.

In analoger Form kann auch ein Anschluss aller Prozessgasabführungen an eine zentrale Einheit vorgenommen sein, so dass lediglich ein, dann entsprechend dimensioniertes Aggregat für den erforderlichen Unterdruck ausreichen kann.

Bei der Erfindung können aber auch mindestens zwei Elektroden gemeinsam an eine automatische HF/VHF-Impedanzanpassungseinheit (Matchbox) angeschlossen sein.

Mit der Erfindung können Modifizierungen an großflächigen Substraten vorgenommen werden, ohne den anlagentechnischen Aufwand und die Betriebskosten proportional zur Flächenvergrößerung erhöhen zu müssen.

Nachfolgend soll die Erfindung beispielhaft näher erläutert werden.

Dabei zeigt:
Figur 1

In perspektivischer Darstellung ein Beispiel einer erfindungsgemäßen Vorrichtung mit zwei Elektroden.

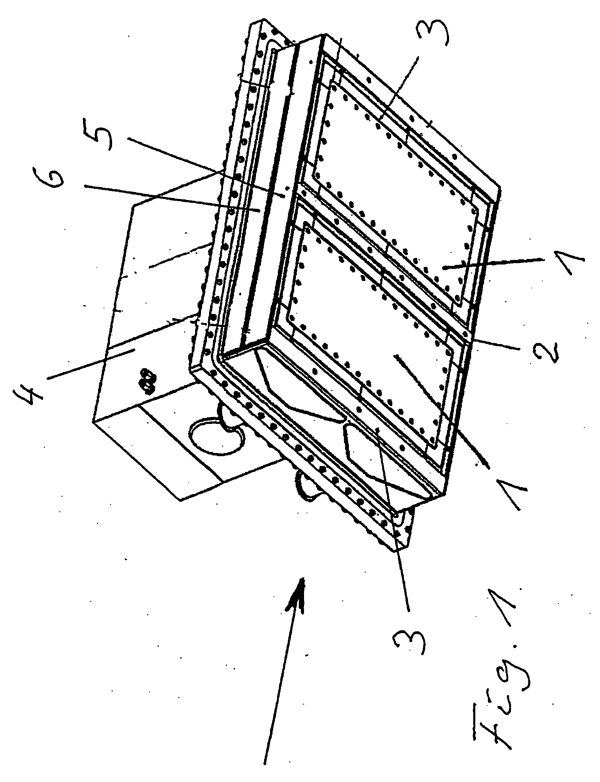

Bei dem in Figur 1 gezeigten Beispiel sind lediglich zwei Elektroden 1 vorhanden, wobei eine Aufskalierung mit weiteren Elektroden 1 ohne weiteres möglich ist. Dabei sind die ebenen planaren Flächen der Elektroden 1 erkennbar. Sie sind umlaufend voneinander elektrisch isoliert und von einer Abschirmung 5, 6 umschlossen. Rückseitig zu den Elektroden ist eine gemeinsame HF/VHF-Impedanzanpassungseinheit 4 angeordnet, über die die Elektroden 1 mit einem nicht dargestellten HF/VHF-Generator verbunden sind.

Die hier nicht dargestellten Substrate werden bei der Oberflächenmodifizierung translatorisch bewegt, wobei die Vorschubachsrichtung mit dem Pfeil angegeben ist. So gelangt ein Substrat zuerst in den Einflussbereich, des mit der hier links dargestellten Elektrode 1 gebildeten Plasmas, um dann bei der weiteren Bewegung in den Einflussbereich des mit der rechts dargestellten Elektrode 1 gebildeten Plasmas zu gelangen.

Zwischen den beiden Elektroden 1 ist eine Prozessgaszuführung 2 angeordnet, mit der Prozessgas für die Plasmabildung an beiden Elektroden 1 zuführbar ist.

Bei diesem Beispiel sind zwei Prozessgasabführungen 3 in Vorschubachsrichtung an den beiden anderen Seiten der Elektroden 1 angeordnet. Prozessgaszuführung 2 und Prozessgasabführungen 3 sind so angeordnet, ausgebildet und ansteuerbar, dass eine homogene Plasmabildung und homogene Verhältnisse über die gesamte zu modifizierende Oberfläche von Substraten eingehalten werden können.

In ebenfalls nicht dargestellter Form können aber auch Prozessgaszuführungen 2 und Prozessgasabführungen 3 in ihrer Anordnung vertauscht und dann zwei Zuführungen und eine Abführung vorhanden sein.

Dies kann aber auch durch eine Steuerung erreicht werden, indem Zuleitungen mit Ventilen so geöffnet und geschlossen werden können, dass entweder Prozessgas zugeführt oder Prozessgas abgesaugt werden kann. Sie werden so umschaltbar betrieben.

## Patentansprüche

1. Vorrichtung zur Modifizierung von Substaroberflächen mit durch HF/VHF-Niederdruckgasentladungen gebildetem Plasma; bei der Substrate translatorisch oder rotatorisch innerhalb eines evakuierten Bereichs einer Kammer bewegt und die zu modifizierende Oberfläche der Substrate dem Einfluss eines Plasmas ausgesetzt werden, dabei
mindestens zwei elektrisch voneinander isolierte Elektroden (1), deren Oberfläche in Richtung auf zu modifizierende Substratoberflächen weisen, in Vorschubachsrichtung der bewegten Substrate nacheinender angeordnet sind; und
jeweils zwischen nacheinander angeordneten Elektroden (1) und am äußeren Rand einer in Vorschubrichtung der Substrate ersten und letzten Elektrode (1) jeweils eine Prozessgaszuführung (2) oder eine Prozessgasabführung (3) angeordnet ist,
**dadurch gekennzeichnet, dass**
die Elektroden (1) gemeinsam an einen HF/VHF-Generator angeschlossen sind und Prozessgaszuführungen (2) und Prozessgasabführungen (3) umschaltbar sind.

2. Vorrichtung nach Anspruch 1, **dadurch gekennzeichnet, dass** in Vorschubrichtung der Substrate Prozessgaszuführungen (2) und Prozessgasabführungen alternierend angeordnet sind.

3. Vorrichtung nach Anspruch 1 oder 2, **dadurch gekennzeichnet, dass** Elektroden (1) senkrecht zur Vorschubrichtung länger sind, als ihre Breite in Vorschubrichtung ist.

4. Vorrichtung nach einem der vorhergehenden Ansprüche, **dadurch gekennzeichnet, dass** die Prozessgaszuführungen (2) an eine gemeinsame zentrale Prozessgasversorgung angeschlossen sind.

5. Vorrichtung nach einem der vorhergehenden Ansprüche, **dadurch gekennzeichnet, dass** die Prozessgaszuführungen (2) so ausgebildet sind, dass ein konstanter Partialdruck an Prozessgas über die gesamte Breite der zu modifizierenden Substratoberfläche eingehalten ist.

6. Vorrichtung nach einem der vorhergehenden Ansprüche, **dadurch gekennzeichnet, dass** mindestens zwei Elektroden (1) gemeinsam an eine automatische HF/VHF-Impedanzanpassungseinheit (4) angeschlossen sind.

## Claims

1. Device for modifying substrate surfaces with plasma created using HF/VHF low-pressure gas discharges; wherein substrates are moved translationally or rotationally within an evacuated zone of a chamber and the surfaces of the substrates to be modified are exposed to the influence of a plasma, wherein
at least two electrodes (1) being electrically insulated from one another and the surfaces thereof pointing in a direction towards the substrate surfaces to be modified are successively arranged in the feed axis direction of the moved substrates; and
a process gas supply line (2) or a process gas discharge line (3) is each disposed between successively arranged electrodes (1) and on the outer periphery of a first and ultimate electrode (1) in the feed axis direction of the substrates,
**characterized in that**
the electrodes (1) are jointly connected to an HF/VHF generator and the process gas supply lines (2) and process gas discharge lines (3) are switchable.

2. Device according to claim 1, **characterized in that** process gas supply lines (2) and process gas discharge lines are arranged alternately in the feed direction of the substrates.

3. Device according to claim 1 or 2, **characterized in that** the electrodes (1) are longer perpendicular to the feed direction compared to the width thereof in the feed direction.

4. Device according to any of the preceding claims, **characterized in that** the process gas supply lines (2) are connected to a common central process gas supply.

5. Device according to any of the preceding claims, **characterized in that**
the process gas supply lines (2) are designed such that a constant partial pressure of process gas is kept over the entire width of the substrate surface to be modified.

6. Device according to any of the preceding claims, **characterized in that** at least two electrodes (1) are jointly connected to an automated HF/VHF impedance matching unit (4).

## Revendications

1. Dispositif pour la modification de surfaces de substrats avec du plasma formé par des décharges de gaz basse pression HF/VHF ; dans lequel des substrats sont déplacés en translation ou en rotation à l'intérieur d'une zone évacuée d'une chambre et la surface à modifier des substrats sont exposés à l'action d'un plasma, au moins deux électrodes (1) isolées électriquement les unes par rapport aux autres, dont les surfaces sont orientées en direction des surfaces de substrats à modifier, sont disposées les unes derrière les autres dans la direction axiale d'avance des substrats déplacés ; et entre les électrodes (1) disposées les unes derrière les autres et sur le bord extérieur d'une première et d'une dernière électrode (1) dans la direction d'avance des substrats, se trouve une alimentation en gaz de process (2) ou une évacuation de gaz de process (3),
**caractérisé en ce que**
les électrodes (1) sont connectées conjointement à un générateur HF/VHF et les alimentations en gaz de process (2) et les évacuations de gaz de process (3) peuvent être commutées.

2. Dispositif selon la revendication 1, **caractérisé en ce que**, dans la direction d'avance des substrats, sont disposées alternativement des alimentations en gaz de process (2) et des évacuations de gaz de process.

3. Dispositif selon la revendication 1 ou 2, **caractérisé en ce que** les électrodes (1) sont plus longues perpendiculairement à la direction d'avance que leur largeur dans la direction d'avance.

4. Dispositif selon l'une des revendications précédentes, **caractérisé en ce que** les alimentations en gaz de process (2) sont connectées à une alimentation en gaz de process centrale commune.

5. Dispositif selon l'une des revendications précédentes, **caractérisé en ce que** les alimentations en gaz de process (2) sont conçues de façon à ce qu'une pression partielle constante du gaz de process soit respectée sur toute la largeur de la surface de substrat à modifier..

6. Dispositif selon l'une des revendications précédentes, **caractérisé en ce qu'**au moins deux électrodes (1) sont connectées conjointement à une unité d'adaptation d'impédance HFNHF (4) automatique.
